# EUROPÄISCHE PATENTSCHRIFT

(11) **EP 1 132 197 B1**
(45) Veröffentlichungstag und Bekanntmachung des Hinweises auf die Patenterteilung: **13.10.2004**
(21) Anmeldenummer: 01101159.0
(22) Anmeldetag: 23.01.2001
(51) Int. Cl.: B32B 27/08, B32B 15/08

(54) **Längsgereckte im Vakuum bedampfte Verpackungsfolien**
Machine direction oriented, CVD/PVD-coated packaging film
Feuilles d'emballage orientées dans le sens de la longueur, revêtues par procédé cvd/pvd sous vide

(30) Priorität: 04.02.2000 DE 10005038
(43) Veröffentlichungstag der Anmeldung: 12.09.2001
(73) Patentinhaber: Wipak Walsrode GmbH & Co. KG, 29656 Walsrode (DE)
(72) Erfinder: Cassel, Antoine, 29664 Walsrode (DE); Brandt, Rainer, Dr., 29664 Walsrode (DE); Kaschel, Gregor, Dr., 29699 Bomlitz (DE)
(74) Vertreter: Kutzenberger, Helga, Dr.

(56) Entgegenhaltungen:
- EP-A- 0 096 581
- EP-A- 0 302 813
- EP-A- 0 686 500
- WO-A-97/38853
- DATABASE WPI Section Ch, Week 199009 Derwent Publications Ltd., London, GB; Class A18, AN 1990-062388 XP002166391 & JP 02 014141 A (KURARAY CO LTD), 18. Januar 1990 (1990-01-18)

## Beschreibung

Die vorliegende Erfindung betrifft längsgereckte im Vakuum bedampfte Folien, die im Bereich technische Folien, Lebensmittelverpackung und weitere Anwendungen verwendet werden.

Es ist bereits bekannt, dass das Aufdampfen im Vakuum, z.B. mit anorganischen Oxiden, einer Folie außer der Optik die Wasserdampf- und Gasbarriere-Eigenschaften verbessert. In vielen Fällen wird die Sauerstoffdurchlässigkeit einer Folie durch eine aufgedampfte organische und/oder anorganische Schicht vermindert. Die organische Barriereschicht wird hauptsächlich durch Coextrusion, durch Kaschierung oder durch Beschichtung eingebracht. Die anorganische Schicht ist meistens eine Metallschicht und wird entweder in Form einer Folie kaschiert oder durch Bedampfen im Vakuum aufgebracht. In vielen Fällen, aus wirtschaftlichen Gründen, wird die organische Schicht kaschiert oder coextrudiert und die anorganische Schicht im Vakuum aufgedampft.

So wird in der US-A-5.153.074 eine Verbundfolie mit einer Schicht aus modifiziertem Maleinsäureanhydrid-Polypropylen (Homopolymer oder Copolymer) beschrieben. Die Coextrusion (oder Kaschierung) erfolgt mit einer Ethylenvinylalkohol (EVOH)-Schicht. Die Folie wird anschließend auf der EVOH-Seite im Vakuum bedampft . Im Prozess wird die Folie biaxial gereckt. Mit diesem Aufbau kann die Folie coextrudiert werden und das Aufdampfen im Vakuum wird auf der EVOH-Schicht durchgeführt, was die Gasdurchlässigkeitseigenschaften verbessert.

In der EP-A-0 340 910 wird eine ähnliche Verpackungsfolie beschrieben. Eine orientierte Polyolefin-Folie (oder regenerierte Cellulose-Folie) wird mit einem Harz (Polyester oder Nitrocellulose) beschichtet. Diese Beschichtung, kombiniert mit einem aufgedampften Metall- bzw. Metalloxid im Vakuum, verbessert die Gas- bzw. die Sauerstoffdurchlässigkeitseigenschaften.

In der EP-A-0 096 581 wird eine Verbundfolie beschrieben, die aus zwei zusammenkaschierten Folien sich ergibt. Eine Folie mit einer außenliegenden Polyolefin-Schicht und einer EVOH, PA, oder Polyethylenterephtalat PET Schicht wird coextrudiert. Diese Folie wird mittels einem Kleber zu einer im Vakuum mit Metall- bzw. Metalloxid bedampften thermoplastischen Folie (PA, Polymethylmethacrylat PMMA, Polyethylen PE, Polypropylen PP, PS, PC, PVC, PVdC, EVOH) kaschiert. Praktisch wird die bedampfte Seite gegen die innere Schicht der ersten Folie kaschiert. Damit werden hohe Gas- bzw. Sauerstoffbarriereeigenschaften mit relativen guten mechanischen Eigenschaften erreicht.

Aus der WO 97/38853 ist eine Verbundfolie bekannt, wobei die Außenschicht aus transparenten Kunststoffmaterialien (PA, PET oder Polyolefine), die Siegelschicht aus Polyolefin (PE oder PP) und die Zwischenschicht aus einem im Vakuum bedampften EVOH vorliegen. Diese Schichten werden einzeln extrudiert bzw. coextrudiert und anschließend durch Primer oder Kleber zusammen beschichtet bzw. kaschiert. Es ist zu bemerken, dass die bedampfte Seite auf der Siegelschichtseite kaschiert wurde. Die gesamte Folie kann eventuell gereckt werden. Mit so einem Aufbau und mit dieser Ausführung werden die Gas- bzw. Sauerstoffbarrierewerte verbessert.

Alle diese bekannten Mehrschichtfolien zeigen aber ihre Grenze, wenn die Kombination
◆ Hohe Gasbarriere
◆ Mechanische Eigenschaften mit guter Knickbruchfestigkeit
◆ Extrusionsbedingungen und Folienqualität
◆ Wirtschaftlichkeit des Prozess erfordert wird.

Mit den Folien der US-A-5.153.074 wird eine gute Gas- bzw. Sauerstoffbarriere durch die EVOH-Schicht, das Aufdampfen von Metallen bzw. Metalloxiden und eventuell die Reckung erreicht, aber diese Folien besitzen für viele Anwendungen ungenügende mechanische Eigenschaften, weil Polypropylen als Basismaterial verwendet wird.

Für die Folien der EP-A-0 340 910 wird auch eine gute Gasbarriere durch das Aufdampfen von Metall bzw. Metalloxid im Vakuum erreicht. Es fehlen aber die mechanischen Eigenschaften, da das Basismaterial Polyolefin ist. Dazu besitzt die Folie kein organisches Gas- bzw. Sauerstoffbarrierematerial, so dass die Folie im Fall einer Delaminierung der bedampften Schicht ihre Barriereeigenschaften verliert.

Die Folien der EP-A-0 096 581 zeigen gute Gasbarriere aber diese Folien werden aus zwei zusammenkaschierten Folien hergestellt. Diese Folien werden separat extrudiert, was den Prozess teurer macht. Es ist bekannt, dass so ein mehrstufiger Prozess teurer als ein einstufiger Prozess wie z.B. die Coextrusion ist. Dazu kommt, dass die Folie nicht gereckt wird, was allgemein die Gas- bzw. Sauerstoffbarriere und die mechanischen Eigenschaften verbessern würde.

Mit den Folien der WO 97/38853 wird eine gute Gasbarriere durch die EVOH-Schicht, das Aufdampfen im Vakuum und eventuell die Reckung erreicht, aber die mechanischen Eigenschaften zeigen sich oft ungenügend. Dazu sollen die Schichten einzeln extrudiert werden, was z.B. für die EVOH-Schicht einen negativen Einfluss hat (Stippen können entstehen). Es ist bekannt, dass sich die EVOH-Extrusion schwierig darstellt, wenn die EVOH-Schmelze direkten Wandkontakt (Metall) hat. So ein kaschierter Verbund wird auch schwer reckbar, was die Verbesserung der Eigenschaften (Gas- bzw. Sauerstoffdurchlässigkeit und mechanischen Eigenschaften) behindert.

Es stellte sich daher die Aufgabe, eine im Vakuum bedampfte gereckte coextrudierbare Mehrschichtfolie mit sehr hohen Gasbarrieren bereitzustellen, die verbesserte mechanische Eigenschaften zeigt. Die bedampfte Schicht der Folie sollte delaminierbar sein und in den delaminierbaren Bereichen eine hohe Gas- bzw. Sauerstoffbarriere haben.

Erfindungsgemäß gelang dies durch eine längsgereckte im Vakuum bedampfte Mehrschichtfolie, bestehend aus einer zwischen mindestens zwei knickbruchfesten Kunststoffschichten eingebetteten Gas- bzw. Sauerstoffsperrschicht, wobei die Gassperrschicht aus EVOH mit einem Ethylen-Anteil von 25 bis 50 Mol% besteht, die anderen Schichten aus Polyamid bestehen, wobei auf einer Außenseite der Folie jeweils ein oder mehrere Elemente der 3. und 4. Haupt- oder Nebengruppe des Periodensystems der Elemente oder deren Oxyde im Vakuum aufgedampft wurden.

Gegenstand der Erfindung ist daher eine längsgereckte im Vakuum bedampfte Mehrschichtfolie aus einer zwischen mindestens zwei Polyamid-Schichten eingebetteten Gassperrschicht, bestehend aus
1. einer Gassperrschicht aus EVOH mit einem Ethylen-Anteil von 25 bis 50 Mol-% und einer Schichtdicke zwischen 0,5 und 10 µm,
2. mindestens zwei Polyamid-Schichten mit je einer Dicke zwischen 3 und 25 µm, wobei
die Folie einer Längsreckung mit einem Reckverhältnis von ca. 1,5:1 bis 8:1 unterworfen wurde und auf die Außenseite der einen Polyamid-Schicht eine Schicht aus einem oder mehreren Elementen aus der Gruppe der 3. und 4. Haupt- und Nebengruppe des Periodensystems der Elemente oder ihrer Oxyde im Vakuum aufgedampft ist.

Die Erfindung betrifft Folien mit einer organischen eingebetteten Gassperrschicht : Ethylenvinylalkohol (EVOH) mit einer Dicke zwischen 0,5 und 10 µm, bevorzugt zwischen 1 und 5 µm. Diese Sperrschicht wird durch Coextrusion zwischen 2 anderen Schichten eingebettet. Die Innen- und Außenschicht besteht aus Polyamid. Die Dicken dieser beiden Außenschichten liegen zwischen 3 und 25 µm, bevorzugt zwischen 5 und 10 µm.

Die im Vakuum aufgedampfte Schicht ist eine Metall- oder Nichtmetalloxyd-Schicht aus der Gruppe der Elemente der 3. und 4. Haupt- und Nebengruppe des Periodensystems der Elemente und ihrer Oxyde, bevorzugt eine unter Vakuum aufgedampfte Aluminium-Schicht, mit einer optischen Dichte von ca. 1,5 bis 3,5, bevorzugt von ca. 2 bis 3. Diese Schicht wird auf eine Außenschicht gedampft. Die Längsreckung erfolgt sich mit einem Reckverhältnis von ca. 1,5:1 bis 8:1, bevorzugt von ca. 2:1 bis 5:1.

Diese im Vakuum aufgedampfte Schicht ist chemisch ablösbar, so dass Schriften, Rautenmuster, Sichtfenster in diese Schicht durch eine Druckmaschine eingearbeitet werden können.

Nach diesem Prozess kann diese Folie weiter verarbeitet werden. Z. B. kann eine Siegelschicht auf der bedampften Seite kaschiert oder beschichtet werden. Die Einbettung dieser Schicht verbessert die Sperreigenschaften des Verbunds, weil die Reibung auf der bedampften Oberfläche vermieden wird, und weil diese aufgedampfte Schicht näher der neutralen Ader der Folie beim Knicken liegt. Diese Schicht wird so beim Knicken weniger beschädigt und die Sperrwirkung wird verbessert.

Das erfundene Verpackungsmaterial beinhaltet eine organische Gasbarriere-Zwischenschicht (EVOH) mit einer guten Sauerstoffbarriere. Es wurde gefunden, dass ein Aufdampfen im Vakuum mit einem der genannten Elemente bzw. Oxyde auf eine derartige Folie, die zusätzlich noch längsgereckt wird, diesen Sperreffekt in überraschender Weise noch erheblich erhöht.

Durch den Einsatz dieser Kombination (im Vakuum bedampfte gereckte Folie mit dem Aufbau PA/EVOH/PA) gelang es, Folien herzustellen, die eine besondere gute Sauerstoff- bzw. auch Heliumbarriere aufweisen, die auch eine sehr gute Knickbruchfestigkeit zeigen, die durch den Aufbau problemlos zu extrudieren (hervorragende Folienqualität ohne Stippen und mit einer ausgezeichneter Optik) und zu recken sind und die durch die Längsreckung stabiler (hohe Festigkeit bei geringen Dehnungen) werden. Diese Stabilität ermöglicht eine problemlose Verarbeitbarkeit auf Druck- und Kaschieranlagen.

Die Herstellung der erfindungsgemäßen Folie erfolgt zweckmäßigerweise über eine Flachfolien-Coextrusion.

Die Kunststoffe (in Granulatform) werden mit Hilfe von Extrudern plastifiziert und anschließend geschmolzen. Die Schmelze wird dann im Werkzeug zu einem dünnen mehrschichtigen Film ausgeformt. Dieser wird nach Austritt aus dem Werkzeug auf eine Gießwalze und dann auf eine Kühlwalze aufgelegt, die die Folie abziehen und gleichzeitig kühlen.

Die Folie wird anschließend in einer Reckzone wieder erwärmt und gleichzeitig längs gezogen, was die Längsreckung ermöglicht. Die Folie kann nach der Reckung aufgewickelt werden.

Das Aufdampfen der gefertigten Folie erfolgt im Vakuum. Die Rolle befindet sich in einem Rezipienten, der durch geeignete Pumpen evakuiert wird. Die Folie wird dann über eine gekühlte Trommel geführt, unterhalb der ein oder mehreren Elemente aus der Gruppe der Elemente der 3. und 4. Haupt- und Nebengruppe des Periodensystems der Elemente oder ein oder mehrere ihrer Oxyde verdampft wird und sich an der vorbeilaufenden Folie niederschlägt. Anschließend wird die Folie im Vakuum wieder aufgewickelt.

Die Sauerstoff- und Heliumdurchlässigkeiten der erfundenen Folien werden gemäß der DIN-Norm 53380, die optische Dichte mit dem Gerät Dainippom Typ DN 500 gemessen.

### Beispiele

### Vergleichbeispiel 1

Eine Folie mit dem Aufbau Polyamid Dicke 6 µm / Ethylenvinylalkohol Dicke 3 µm / Polyamid Dicke 6 µm (Verbundfolie = 12 µm) wird coextrudiert. Diese Folie zeigt eine Sauerstoffdurchlässigkeit von ca. 2 cm³/m².day.bar (bei 23°C, 0% Feuchtigkeit).

### Vergleichbeispiel 2

Eine ähnliche Folie mit dem Aufbau Polyamid Dicke 6 µm / Ethylenvinylalkohol Dicke 3µm / Polyamid Dicke 6 µm (Verbundfolie = 12 µm) wird coextrudiert und längsgereckt. Die Sauerstoffdurchlässigkeit erreicht ca. 1,5 cm³/m².day.bar (bei 23°C, 0 % Feuchtigkeit), was schon den Einfluss der Längsreckung auf die Sauerstoffdurchlässigkeit zeigt. Die Heliumdurchlässigkeit ist ca. 0,5 cm³/m².day.bar (bei 23°C, 0% Feuchtigkeit), was schon ein hervorragender Wert ist.

### Beispiel 1

Die gleiche längsgereckte Folie wie im Vergleichbeispiel 2 mit dem Aufbau Polyamid Dicke 6 µm / Ethylenvinylalkohol Dicke 3µm / Polyamid Dicke 6 µm (Verbundfolie = 12 µm) wurde mit Aluminium im Vakuum beschichtet (Optische Dichte = 2,1). Die Sauerstoffdurchlässigkeit liegt dann bei ca. 0,3 cm³/m².day.bar und die Heliumdurchlässigkeit bei ca. 0,01 cm³.m².day.bar (bei 23°C, 0 % Feuchtigkeit), was eine erhebliche Verbesserung im Vergleich mit der nicht metallisierten Folie bedeutet.

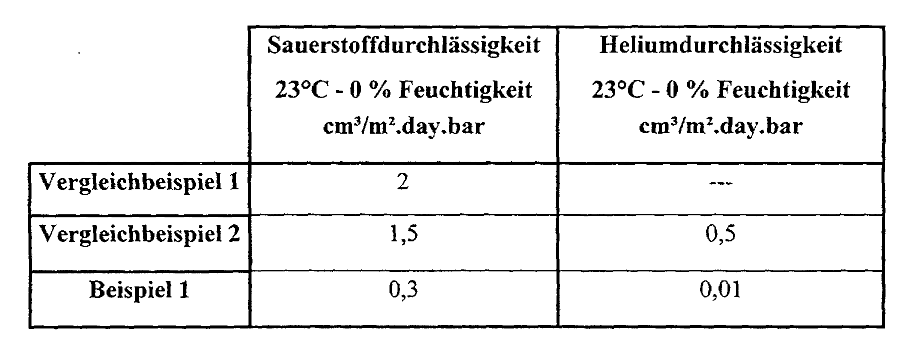

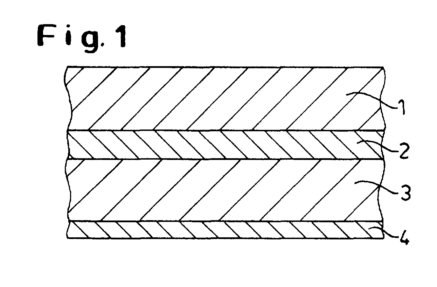

Die Fig. 1 zeigt diesen Folienaufbau (vom Beispiel 1). Die Schichten 1 und 3 sind Polyamid, die Schicht 2 ist Ethylenvinylalkohol und die Schicht 4 ist das aufgedampfte Aluminium.

## Patentansprüche

1. Längsgereckte, im Vakuum bedampfte Mehrschichtfolie aus einer zwischen mindestens zwei Polyamid-Schichten eingebetteten Gassperrschicht, bestehend aus
1. einer Gassperrschicht aus EVOH mit einem Ethylen-Anteil von 25 bis 50 Mol-% und einer Schichtdicke zwischen 0,5 und 10 µm,
2. mindestens zwei Polyamid-Schichten mit je einer Dicke zwischen 3 und 25 µm, wobei
die Folie einer Längsreckung mit einem Reckverhältnis von ca. 1,5:1 bis 8:1 unterworfen wurde und auf die Außenseite einer Polyamid-Schicht eine Schicht aus einem oder mehreren Elementen aus der Gruppe der Elemente der 3. und 4. Haupt- und Nebengruppe des Periodensystems der Elemente oder ihrer Oxide im Vakuum aufgedampft ist.

2. Folie nach Anspruch 1, **dadurch gekennzeichnet, dass** die Außenseite einer Polyamid-Schicht mit einem oder mehreren Elementen aus der Gruppe B, Al, Ti, Si oder mit einem Oxid aus der Gruppe SiOₓ, AlₓO_{y}, TiO₂ oder BₓO_{y} bedampft ist.

3. Folie nach Anspruch 1 oder 2, **dadurch gekennzeichnet, dass** die Außenseite einer Polyamid-Schicht mit Aluminium mit einer optischen Dichte von 1,5 bis 3,5 bedampft ist.

4. Folie nach einem der Ansprüche 1 bis 3, **dadurch gekennzeichnet, dass** die aufgedampfte Schicht partiell zur Einarbeitung von Schriften, Rautenmuster, Sichtfenstern ablösbar ist.

5. Folie nach einem der Ansprüche 1 bis 4, **dadurch gekennzeichnet, dass** die Gassperrschicht eine Schichtdicke zwischen 1 und 5 µm aufweist.

6. Folie nach einem der Ansprüche 1 bis 5, **dadurch gekennzeichnet, dass** die Polyamid-Schichten je eine Dicke zwischen 5 und 10 µm aufweisen.

7. Folie nach einem der Ansprüche 1 bis 6, **dadurch gekennzeichnet, dass** das Reckverhältnis ca. 2:1 bis 5:1 beträgt.

8. Folie nach einem der Ansprüche 1 bis 7, **dadurch gekennzeichnet, dass** sie auf der bedampften Seite mit einer Siegelschicht kaschiert oder beschichtet ist.

9. Verwendung einer Folie nach einem der Ansprüche 1 bis 8 als Verpackungsmaterial.

10. Verwendung einer Folie nach einem der Ansprüche 1 bis 8 als Lebensmittelverpackung.

## Claims

1. Longitudinally stretched multilayer film which has been subjected to vacuum deposition and which comprises, embedded between at least two polyamide layers, a gas-barrier layer, composed of
1. a gas-barrier layer comprising EVOH with an ethylene content of from 25 to 50 mol% and with a layer thickness of from 0.5 to 10 µm,
2. at least two polyamide layers, the thickness of each being from 3 to 25 µm, where
the film has been subjected to longitudinal stretching with a stretching ratio of about 1.5:1 - 8:1, and a layer comprising one or more elements from the group of the elements of the 3rd and 4th main and transition groups of the Periodic Table of the Elements, or of their oxides, has been applied by vacuum deposition to the outer side of one polyamide layer.

2. Film according to Claim 1, **characterized in that** the outer side of one polyamide layer has been subjected to vapour deposition, of one or more elements from the group B, Al, Ti, Si, or of an oxide from the group SiOₓ, AlₓO_{y}, TiO₂ or BₓO_{y}.

3. Film according to Claim 1 or 2, **characterized in that** the outer side of one polyamide layer has been subjected to vapour deposition of aluminium, with an optical density of from 1.5 to 3.5.

4. Film according to any of Claims 1 to 3, **characterized in that** the vapour-deposited layer is partially detachable in order to incorporate inscriptions, rhombic patterns, or viewing windows.

5. Film according to any of Claims 1 to 4, **characterized in that** the gas-barrier layer has a thickness of from 1 to 5 µm.

6. Film according to any of Claims 1 to 5, **characterized in that** each of the polyamide layers has a thickness of from 5 to 10 µm.

7. Film according to any of Claims 1 to 6, **characterized in that** the stretching ratio is about 2:1 - 5:1.

8. Film according to any of Claims 1 to 7, **characterized in that** the side subjected to vapour deposition has been laminated to, or coated with, a sealable layer.

9. Use of a film according to any of Claims 1 to 8 as packaging material.

10. Use of a film according to any of Claims 1 to 8 as packaging for food or drink.

## Revendications

1. Feuille multicouche étirée longitudinalement et métallisée sous vide, constituée d'une couche étanche aux gaz insérée entre au moins deux couches de polyamide, consistant en
1. une couche étanche aux gaz en EVOH contenant une fraction d'éthylène de 25 à 50% molaires et d'une épaisseur de couche comprise entre 0,5 et 10 µm,
2. au moins deux couches de polyamide ayant chacune une épaisseur comprise entre 3 et 25 µm, où
la feuille a été soumise à un étirage longitudinal avec un rapport d'étirage d'environ 1,5:1 à 8:1 et, sur la face extérieure d'une couche de polyamide, a été métallisée sous vide une couche constituée d'un ou plusieurs éléments du groupe des éléments des 3^{ème} et 4^{ème} groupes principaux, et sous-groupes du système périodique des éléments ou de leurs oxydes.

2. Feuille selon la revendication 1, **caractérisée en ce que** l'on dépose sur la face extérieure d'une couche de polyamide, par métallisation sous vide, un ou plusieurs éléments du groupe formé par B, Al, Ti, Si, ou d'un oxyde du groupe formé par SiOₓ, AlₓO_{y}, TiO₂ ou BₓO_{y}.

3. Feuille selon la revendication 1 ou 2, **caractérisée en ce que** la face extérieure d'une couche de polyamide est revêtue par métallisation sous vide d'aluminium, avec une densité optique de 1,5 à 3,5.

4. Feuille selon l'une des revendications 1 à 3, **caractérisée en ce que** la couche métallisée sous vide peut être partiellement pelliculée aux fins d'incorporation de mentions écrites, de quadrillages, de fenêtres transparentes.

5. Feuille selon l'une des revendications 1 à 4, **caractérisée en ce que** la couche étanche aux gaz présente une épaisseur de couche comprise entre 1 et 5 µm.

6. Feuille selon l'une des revendications 1 à 5, **caractérisée en ce que** les couches de polyamide ont chacune une épaisseur comprise entre 5 et 10 µm.

7. Feuille selon l'une des revendications 1 à 6, **caractérisée en ce que** le rapport d'étirage est d'environ 2:1 à 5:1.

8. Feuille selon l'une des revendications 1 à 7, **caractérisée en ce qu'**elle est stratifiée ou revêtue avec une couche d'étanchéité sur la face métallisée sous vide.

9. Utilisation d'une feuille selon l'une des revendications 1 à 8 en tant que matériau d'emballage.

10. Utilisation d'une feuille selon l'une des revendications 1 à 8 en tant qu'emballage de produits alimentaires.
